# EUROPEAN PATENT APPLICATION

(11) **EP 4 539 245 A1**
(43) Date of publication of application: **16.04.2025**
(21) Application number: 23819806.3
(22) Date of filing: 05.06.2023
(51) Int. Cl.: H01P 1/16, C01B 32/26, C23C 16/511, C30B 29/04, H01L 21/205, H01P 5/103, H05H 1/46

(54) **MICROWAVE PLASMA CVD DEVICE**

(30) Priority: 08.06.2022 JP 2022092952; 08.06.2022 JP 2022092953
(71) Applicant: National Institute of Advanced Industrial Science and Technology, Chiyoda-ku Tokyo 100-8921 (JP)
(72) Inventor: YAMADA, Hideaki, Tsukuba-shi, Ibaraki 305-8560 (JP); CHAYAHARA, Akiyoshi, Tsukuba-shi, Ibaraki 305-8560 (JP); MOKUNO, Yoshiaki, Tsukuba-shi, Ibaraki 305-8560 (JP)
(74) Representative: V.O.
(86) International application number: PCT/JP2023/020843
(87) International publication number: WO 2023/238826

(57) **Abstract**

A microwave plasma CVD device (1) includes a chamber (10A), a mounting table (110A) provided in a central portion of the chamber (10A) in a plan view of the chamber (10A), a coaxial structural portion (80A) including a central conductor (81) which is located in the central portion of the chamber (10A) in a plan view of the chamber (10A) and is parallel to an axial direction of a symmetric axis in an internal resonance mode of the chamber (10A) and an outer conductor (82) located around the central conductor (81), a plurality of microwave introduction ports (20), (20), ... that are provided in the coaxial structural portion (80A) of the chamber (10A) and are coupled to match the internal resonance mode of the chamber (10A), and a microwave introduction window (30A) that transmits microwaves while forming a pressure partition wall between the chamber (10A) and a waveguide portion (40A).

## Description

### TECHNICAL FIELD

The present invention relates to a microwave plasma CVD device.

Priority is claimed on Japanese Patent Application No. 2022-092952 and Japanese Patent Application No. 2022-092953, filed June 8, 2022, the contents of which are incorporated herein by reference.

### BACKGROUND ART

Most of the artificial diamonds used in industry as cutting tool materials and abrasive particles have been produced by an ultra-high pressure synthesis method, but in recent years, the use of a gas phase synthesis method has become increasingly common. The diamond produced using the gas phase synthesis method is primarily used in window materials, heat sinks, semiconductors, and quantum applications. These uses require large areas and/or high purity.

As devices for gas phase synthesis, a hot filament CVD (chemical vapor deposition) device and a microwave plasma CVD device are mainly used in industry. Of these, the microwave plasma CVD device uses microwaves with a frequency of 2.45 GHz or 915 MHz to generate microwave discharge in a gas mainly consisting of methane and hydrogen at a pressure (a vacuum level) of 10 to 300 Torr, thereby forming plasma to grow a diamond on a substrate. In a case in which the microwave plasma CVD device is used to synthesize a diamond, it is possible to grow the diamond at a speed about 10 times faster than that of the hot filament CVD device, which is expected to reduce production costs. In addition, since a filament material is not mixed into a film, it is possible to grow a high-purity film that is required for semiconductor applications, and the like.

There are various types of microwave plasma CVD devices, and a plasma shape is controlled by devising a shape of a chamber as a discharge container and a method for introducing microwaves. Major chamber shapes include an NIRIM type devised by the former National Institute for Research in Inorganic Materials (currently National Institute for Materials Science) (Non Patent Document 1), an ASTeX type developed by ASTeX, Inc., USA (Patent Document 1), a device called CYRANNUS commercialized by iPlas, Germany (Patent Document 2), a device called AIXTRON developed by the Fraunhofer Institute, Germany (Non Patent Document 2) and its variations (Non Patent Documents 3 to 5), and the like. As another microwave introduction method, there is a method in which microwaves are supplied to a chamber from a plurality of waveguide tubes with staggered irradiation timings (Patent Document 3).

In addition, the microwave plasma CVD device is provided with a mode converter that converts a mode of the microwaves transmitted into the chamber. For example, there is a mode converter having a rectangular waveguide tube in a TE mode and a cylindrical waveguide tube in a TM mode (Patent Documents 4 to 6). In addition, in a mode converter from a TE rectangular waveguide to a TE cylindrical waveguide tube, there is a mode converter that temporarily converts the waveguide into a TM cylindrical waveguide, divides the waveguide into four, and then combines the waveguides again to convert the waveguide into a large diameter cylindrical waveguide (Patent Documents 4 and 5).

### Citation List

### Patent Document

Patent Document 1: Japanese Patent No. 3483147
Patent Document 2: Published Japanese Translation No. 2000-515296 of the PCT International Publication
Patent Document 3: Japanese Unexamined Patent Application, First Publication No. H4-144992
Patent Document 4: Japanese Unexamined Patent Application, First Publication No. H02-009202
Patent Document 5: Japanese Unexamined Patent Application, First Publication No. H10-126101
Patent Document 6: Japanese Unexamined Patent Application, First Publication No. 2017-5533

### Non Patent Documents

Non Patent Document 1: Journal of Crystal Growth, 62 (1983), 642-644.
Non patent Document 2: Applied Physics Letters, 72, 1149, 1998
Non patent Document 3: Diamond & Related Materials, 30, (2012), 15-19
Non patent Document 4: Diamond & Related Materials, 51, (2015), 24-29
Non patent document 5: Vacuum, 117, (2015), 112-120

### SUMMARY OF INVENTION

### Technical Problem

The microwave plasma CVD device includes at least a microwave power source that generates microwaves, a chamber for synthesizing a diamond, and a waveguide tube that introduces the microwaves from the microwave power source to the chamber. The rapid growth of a large area diamond using the microwave plasma CVD device requires the introduction of high power microwaves. In that case, however, abnormal discharge may occur within the waveguide tube. In particular, in a high humidity environment, the occurrence of the abnormal discharge becomes noticeable in the waveguide tube that introduces the microwaves into the chamber, and in the applicator including a rectangular waveguide tube and a cylindrical waveguide tube that are connected to each other, which are employed in the ASTeX type of the microwave plasma CVD devices described above.

In addition, in a case in which a large gemstone or an ingot of a semiconductor diamond is produced, a sufficient space is required near a crystal to install mechanisms for cooling an object to be processed (the crystal), automatically raising and lowering the object to be processed, and controlling a temperature distribution of the object to be processed. Specifically, in a case in which the crystal is mounted on the mounting table, it is desirable that there be no obstacle below the mounting table, such as a microwave introduction portion, that would impede the installation of the above-described mechanism.

Furthermore, among the above microwave plasma CVD devices, the NIRIM type, the CYRANNUS, and the AIXTRON have a microwave introduction window made of quartz or the like that is installed as a vacuum partition wall between the chamber and the outside on or near an extension line in an in-plane direction of the upper surface (the growth surface) of the crystal. Therefore, this window may be etched by the plasma, and quartz components that become suspended by the etching may be mixed into the diamond on the substrate, causing a deterioration in the quality of the object to be processed such as a bulk. It is considered that this phenomenon becomes more noticeable when high power microwaves are applied, because the plasma expands and approaches the microwave introduction window.

In addition, the rapid growth of a large area diamond using the microwave plasma CVD device requires the introduction of high power microwaves. However, in the microwave mode converter as described above, in a case in which high power microwaves are introduced, the abnormal discharge may occur in the waveguide tube. In particular, the occurrence of the abnormal discharge within the waveguide tube becomes noticeable in a high humidity environment.

In addition, in Patent Document 4, the waveguide tube has a multistage structure of rectangle → cylinder → four rectangles → four twisted tubes → four rectangles → cylinder, resulting in a large and complicated mode converter. In Patent Document 5, although there is an advantage that the diameter can be increased without using a tapered tube, the mode converter is still large and complicated. Furthermore, in recent years, research and development into the structure and shape of the mode converter has been progressing in order to meet the need for larger bulk. However, in Patent Document 6, the diameter of the cylindrical waveguide tube is approximately the same as a long side of the rectangular waveguide tube, and in order to increase the diameter, it is necessary to further connect a tapered tube of a certain length to the cylindrical waveguide tube, which leads to a complex structure.

Thus, when high power microwaves are introduced into the chamber of the microwave plasma CVD device or the etching device, a radar antenna, or the like, there is a demand for suppressing the abnormal discharge in the mode converter and for simplifying and miniaturizing the mode converter.

The present invention has been proposed in view of the above-mentioned circumstances of the related art, and an object of the present invention is to provide a microwave plasma CVD device by which abnormal discharge can be suppressed even when high power microwaves are introduced, crystal quality can be improved by ensuring good access to a crystal, and furthermore a high purity diamond can be produced.

In addition, another object of the present invention is to provide a microwave mode converter by which abnormal discharge can be suppressed even when high power microwaves are introduced and the diameter of a cylindrical waveguide tube or a coaxial waveguide tube in a conversion part can be arbitrarily expanded while simplification and miniaturization are realized.

### Solution to Problem

To achieve the above objects, the present invention provides the following means.
[1] A microwave plasma CVD device including:
   a chamber;
   a mounting table provided in a central portion of the chamber in a plan view of the chamber;
   a raw material gas introduction portion for introducing a raw material gas into the chamber;
   a gas exhaust portion for exhausting gas from the chamber;
   a plurality of microwave introduction ports coupled to match an internal resonance mode of the chamber;
   one or more microwave introduction windows that transmit microwaves while forming a pressure partition wall between the chamber and a waveguide portion;
   the waveguide portion connected to the plurality of microwave introduction ports; and
   a microwave oscillation source connected to the waveguide portion.
[2] The microwave plasma CVD device according to [1] above, further including a coaxial structural portion that includes a central conductor which is located at a central portion of the chamber in a plan view of the chamber and is parallel to an axial direction of a symmetric axis of the internal resonance mode of the chamber and an outer conductor located around the central conductor,
   wherein the plurality of microwave introduction ports are provided in the coaxial structural portion of the chamber.
[3] The microwave plasma CVD device according to [1] or [2] above, wherein an introduction direction of the microwaves introduced from the plurality of microwave introduction ports is parallel to an axial direction of a symmetric axis of the internal resonance mode of the chamber or an axial direction of the central conductor.
[4] The microwave plasma CVD device according to [2], wherein an introduction direction of the microwaves introduced from the plurality of microwave introduction ports is perpendicular to the axial direction of the symmetric axis of the internal resonance mode of the chamber or an axial direction of the central conductor.
[5] The microwave plasma CVD device according to [2] above, wherein opening surfaces of the plurality of microwave introduction ports are disposed around the central conductor in a plan view of the chamber and are provided parallel to an axial direction of the central conductor.
[6] The microwave plasma CVD device according to [2] above, wherein opening surfaces of the plurality of microwave introduction ports are disposed around the central conductor in a plan view of the chamber and are provided perpendicular to an axial direction of the central conductor.
[7] The microwave plasma CVD device according to any one of [1] to [6] above, wherein opening surfaces of the plurality of microwave introduction ports are disposed in a circumferential direction of the chamber with a symmetric axis of the internal resonance mode of the chamber or a central axis of the central conductor as a reference in a plan view of the chamber.
[8] The microwave plasma CVD device according to [2] above,
   wherein the waveguide portion includes a rectangular waveguide tube and a ring-shaped resonator that is coupled to the rectangular waveguide tube and is provided on the coaxial structural portion of the chamber,
   wherein the ring-shaped resonator is coupled to the coaxial structural portion via the plurality of microwave introduction ports provided in the resonator, and
   wherein a TE mode of the microwaves that are transmitted through the rectangular waveguide tube is converted into a TEM mode of the microwaves that are transmitted through the coaxial structural portion via the ring-shaped resonator.
[9] A microwave mode converter including a rectangular waveguide tube, a ring-shaped resonator coupled to the waveguide tube, and a coaxial structural portion coupled to the resonator,
   wherein a TE mode of microwaves that are transmitted through the rectangular waveguide tube is converted into a TEM mode of the microwaves that are transmitted through the coaxial structural portion via the ring-shaped resonator.
[10] The microwave mode converter according to [9] above, wherein the resonator has an outer circumferential side wall and an inner circumferential side wall and has a plurality of microwave introduction ports disposed side by side in a circumferential direction of the inner circumferential side wall.
[11] The microwave mode converter according to [10] above, wherein opening surfaces of the plurality of microwave introduction ports are provided parallel to an axial direction of a symmetric axis of the resonator and are disposed side by side to be rotationally symmetric in the circumferential direction of the inner circumferential side wall with the symmetric axis of the resonator as a reference.
[12] The microwave mode converter according to [10] or [11] above,
   wherein each of the microwave introduction ports is a linear or rectangular slit, and
   wherein the slit is disposed such that a long side thereof is parallel to a magnetic field direction at the slit in correspondence with a resonance mode in the resonator and such that a direction of a magnetic field formed in the coaxial structural portion by the slit is the same as a direction of a magnetic field in the coaxial structural portion.

### Advantageous Effects of Invention

According to the present invention, abnormal discharge can be suppressed even when high power microwaves are introduced, crystal quality can be improved by ensuring good access to a crystal, and furthermore a high purity diamond can be produced.

In addition, according to the present invention, it is possible to realize a microwave mode converter by which abnormal discharge can be suppressed even when high power microwaves are introduced and the diameter of a cylindrical waveguide tube or a coaxial waveguide tube in a conversion part can be arbitrarily expanded while simplification and miniaturization of the microwave mode converter are realized. In a case in which this microwave mode converter is applied to a microwave plasma CVD device, it is possible to ensure a sufficient space required for producing an object to be processed such as a large bulk.

### BRIEF DESCRIPTION OF DRAWINGS

FIG. 1 is a partial cross-sectional perspective view showing an example of a configuration of a microwave plasma CVD device according to an embodiment of the present invention.
FIG. 2 is a side view showing the configuration of the microwave plasma CVD device of FIG. 1.
FIG. 3A is a cross-sectional view that schematically shows the example of the configuration of the microwave plasma CVD device of FIG. 1, and FIG. 3B is a cross-sectional view along line A-A.
FIG. 4 is a perspective view showing a configuration of a microwave mode converter provided on a coaxial structural portion of FIG. 1.
FIG. 5A is a plan view of the microwave mode converter of FIG. 4, and FIG. 5B is a cross-sectional view along line B-B.
FIGS. 6A and 6B are cross-sectional views that schematically show modification examples of the microwave plasma CVD device of FIG. 3A.
FIGS. 7A to 7C are cross-sectional views that schematically show other modification examples of the microwave plasma CVD device of FIG. 3A.
FIG. 8A is a side view that schematically shows an example in which a ring-shaped resonator of FIG. 7A is replaced with a plurality of waveguide tubes, and FIG. 8B is a cross-sectional view along line C-C.
FIG. 9 is a diagram showing a distribution of an electric field intensity obtained by a simulation of Example 1.
FIG. 10A is a diagram showing a distribution of an electric field intensity obtained by a simulation of Example 2, and FIG. 10B is a diagram showing the distribution of the magnetic field intensity in a cross section along line D-D.
FIG. 11 is a perspective view showing a configuration of a microwave mode converter in a microwave plasma CVD device of the related art.
FIG. 12 is a diagram showing a distribution of an electric field intensity obtained by a simulation of Comparative Example 1.

### DESCRIPTION OF EMBODIMENTS

Hereinafter, embodiments of the present invention will be described in detail with reference to the drawings.

In the drawings which will be used in the following description, in order to make constituent elements easier to see, the dimensions of the constituent elements may be shown at different scales, and the dimensional ratios of the constituent elements may not necessarily be the same as the actual ones. In addition, the materials and the like which will be exemplified in the following description are merely examples, and the present invention is not necessarily limited thereto and can be carried out with appropriate modifications without changing the gist of the present invention.

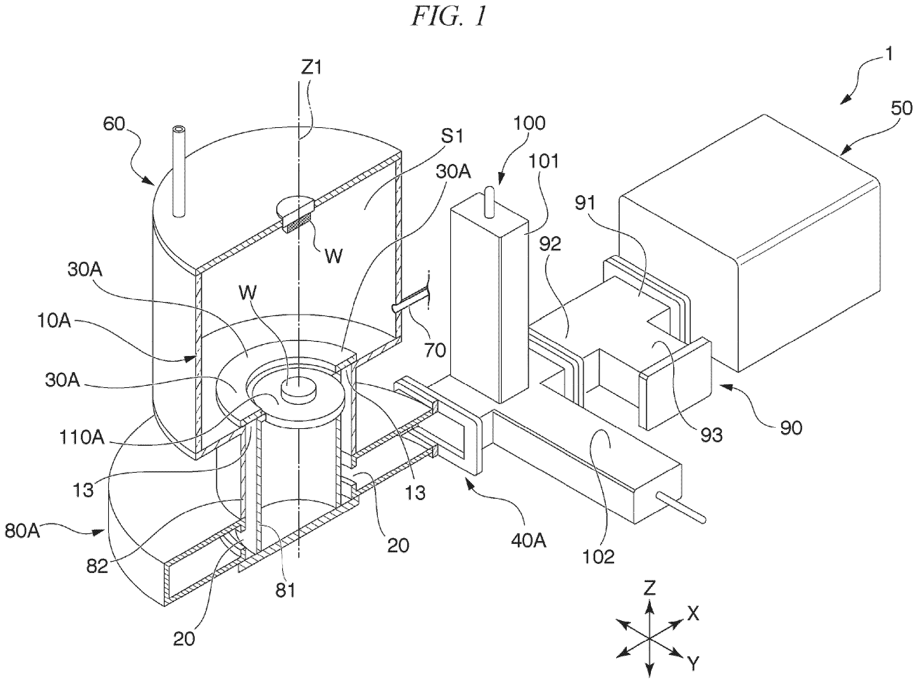

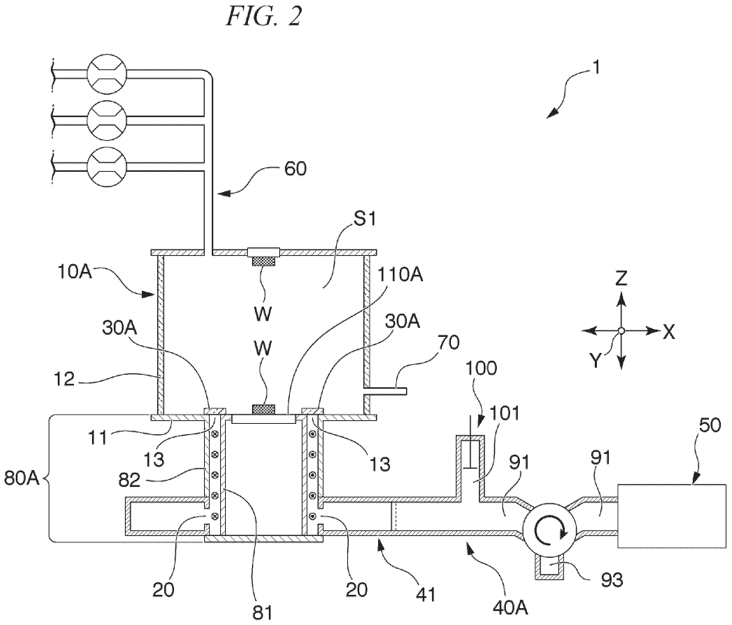

FIG. 1 is a partial cross-sectional perspective view showing an example of a configuration of a microwave plasma CVD device according to an embodiment of the present invention, and FIG. 2 is a side view showing the configuration of the microwave plasma CVD device of FIG. 1. The microwave plasma CVD device 1 is a device that generates plasma to precipitate or deposit a substance such as a diamond on a workpiece such as a substrate.

As shown in FIGS. 1 and 2, a microwave plasma CVD device 1 includes a chamber 10A, a mounting table 110A provided in a central portion of the chamber 10A in a plan view of the chamber 10A, a coaxial structural portion 80A including a central conductor 81 which is located in the central portion of the chamber 10A in a plan view of the chamber 10A and is parallel to an axial direction of a symmetric axis Z1 in an internal resonance mode of the chamber 10A and an outer conductor 82 located around the central conductor 81, a plurality of microwave introduction ports 20, 20, ... that are provided in the coaxial structural portion 80A of the chamber 10A and are coupled to match the internal resonance mode of the chamber 10A, a microwave introduction window 30A that transmits microwaves while forming a pressure partition wall between the chamber 10A and a waveguide portion which will be described below, the waveguide portion 40A connected to the plurality of microwave introduction ports 20, 20, ... , and a microwave oscillation source 50 connected to the waveguide portion 40A.

The mounting table 110A may be provided on an upper end portion of the central conductor 81 in an axial direction, or may be installed, for example, on an upper surface of the chamber 10A facing the upper end portion of the central conductor 81 in the axial direction. The upper end portion of the central conductor 81 in the axial direction is desirably located above a bottom surface of the chamber 10A from the viewpoint that the microwave introduction window 30A should not be exposed to the plasma. The mounting table 110A is not particularly limited as long as a workpiece W can be stably mounted on it, and it is preferable that the mounting table 110A be made of molybdenum (Mo) or the like from the viewpoint that it should be difficult to be etched by the plasma as a conductive and heat-resistant material. In addition, the mounting table 110A may have a multi-layer structure constituted by a plurality of layers made of different materials. The multi-layer structure is not particularly limited and may be, for example, a two-layer structure in which a lower layer is made of copper (for water cooling) and an upper layer is made of molybdenum. In addition, the multi-layer structure may be a three-layer structure in which a bottom layer is made of copper (for water cooling), a middle layer is made of SUS, and a top layer is made of molybdenum.

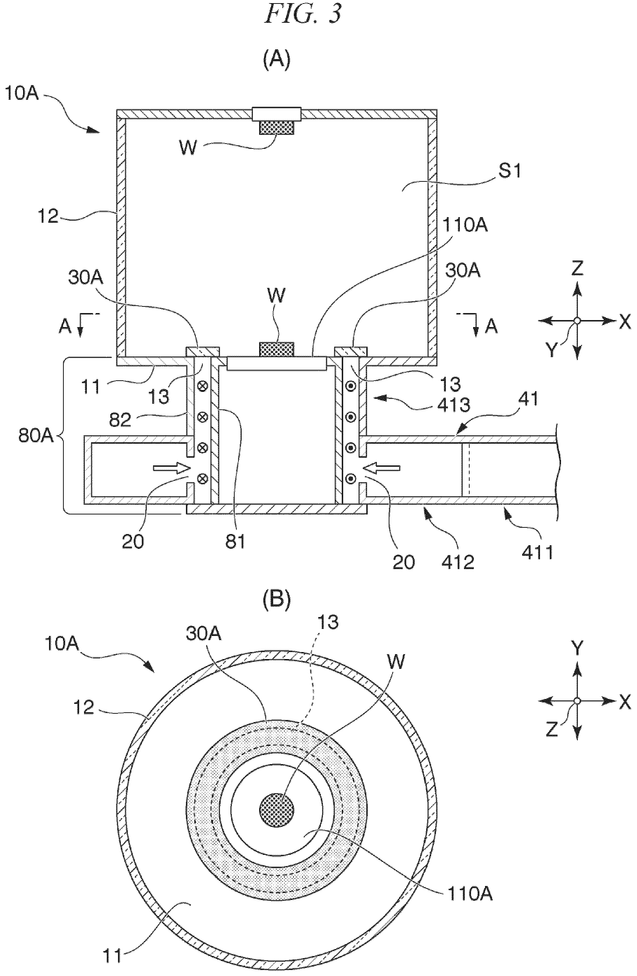

The chamber 10A is a sealed container having at least a bottom wall 11 and a side wall 12 shown in FIGS. 2 and 3 and having therein a sealed space S1 shown in FIGS. 1 to 3. The chamber 10A is made of a metal such as stainless steel or an aluminum alloy, and is equipped with an observation window (quartz, heat-resistant glass) as necessary. In the present embodiment, the chamber 10A has a uniaxially symmetric shape and has a rotationally symmetric shape with a symmetric axis Z1 parallel to a z direction as a reference. The chamber 10A has, for example, a substantially cylindrical shape in a plan view, but the present invention is not limited to this.

The microwave plasma CVD device 1 includes a raw material gas introduction portion 60 for introducing a raw material gas into the chamber 10A, and a gas exhaust portion 70 for exhausting gas from the chamber 10A. Through the raw material gas introduction portion 60, the raw material gas, which is a raw material for a coating to be formed on the workpiece W, is supplied into the sealed space S1 of the chamber 10A. The raw material gas is, for example, a mixed gas containing methane (CH₄) and hydrogen (H₂) as main components. The raw material gas may further contain argon (Ar), oxygen (O₂), and, for the purpose of intentional doping as an impurity, a compound containing nitrogen (N₂), phosphorus (P), boron (B), or the like. The gas exhaust portion 70 has a pump that exhausts gas from the sealed space S1 and an exhaust resistance controller (not shown). By driving the pump, the sealed space S1 can be maintained in a reduced pressure state at a constant pressure (preferably a vacuum state).

FIG. 3A is a cross-sectional view that schematically shows the example of the configuration of the microwave plasma CVD device of FIG. 1, and FIG. 3B is a cross-sectional view along line A-A.

In the present embodiment, the bottom wall 11 of the chamber 10A is provided with a coaxial opening portion 13 that communicates with a plurality of microwave introduction ports 20, 20, ... provided in the coaxial structural portion 80A. An opening surface of the coaxial opening portion 13 is disposed around the central conductor 81 in a plan view of the chamber 10A and is provided perpendicular to an axial direction of the central conductor 81 (the z direction). The coaxial opening portion 13 has, for example, a ring shape, and is provided such that an axis direction thereof is parallel to the axial direction of the central conductor 81 (the z direction).

The opening surface of the coaxial opening portion 13 is disposed to be coaxial with the central axis of the central conductor 81 of the chamber 10A in a plan view of the chamber 10A. The coaxial opening portion 13 has a circumferential direction and a radial direction and is provided such that the circumferential direction is aligned with a circumferential direction of the chamber 10A.

In the present embodiment, the microwave introduction window 30A is mounted on the bottom wall 11 of the chamber 10A to cover the coaxial opening portion 13. The microwave introduction window 30A is placed between the chamber 10A (a reduced pressure region) and the waveguide portion 40A (an atmospheric pressure region) (see FIGS. 1 and 2). The microwave introduction window 30A is preferably made of a material (dielectric) that transmits the microwaves without loss and is made of, for example, quartz.

Similar to the coaxial opening portion 13, the microwave introduction window 30A is also provided parallel to the axial direction of the symmetric axis of the internal resonance mode of the chamber 10A or the axial direction of the central conductor 81 in a plan view of the chamber 10A. The microwave introduction window 30A is not limited to the ring shape and may have a shape other than the ring shape as long as it is axially symmetric and can close the coaxial opening portion 13.

The waveguide portion 40A shown in FIG. 2 transmits the microwaves from a microwave oscillation source 50 to the chamber 10A via the plurality of microwave introduction ports 20, 20, .... In the present embodiment, as shown in FIG. 3, the waveguide portion 40A has a ring-shaped resonator 412 that is coupled to a rectangular waveguide tube 411 and is provided on the coaxial structural portion 80A of the chamber 10A. The coaxial structural portion 80A and the ring-shaped resonator 412 constitute a microwave mode converter 41. The ring-shaped resonator 412 is coupled to the coaxial structural portion 80A via the plurality of microwave introduction ports 20, 20, ... provided in the resonator.

In the configuration shown in FIG. 3, the internal resonance mode is axially symmetric, and an introduction direction of the microwaves introduced from the plurality of microwave introduction ports 20, 20, ... is perpendicular to the axial direction of the symmetric axis of the internal resonance mode of the chamber 10A or the axial direction of the central conductor 81. In other words, the normal line at the center of an opening surface of each of the plurality of microwave introduction ports 20, 20, ... is perpendicular to the above symmetric axis. In addition, the opening surfaces of the plurality of microwave introduction ports 20, 20, ... are disposed around the central conductor 81 in a plan view of the chamber 10A and are provided parallel to the axial direction of the central conductor 81. When microwaves are introduced from the plurality of microwave introduction ports 20, 20, ... into the coaxial structural portion 80A, which will be described below, in a direction perpendicular to the symmetric axis, the microwaves are then transmitted through the microwave introduction window 30A of the coaxial opening portion 13 and are proceeded to an upper portion of the chamber 10A.

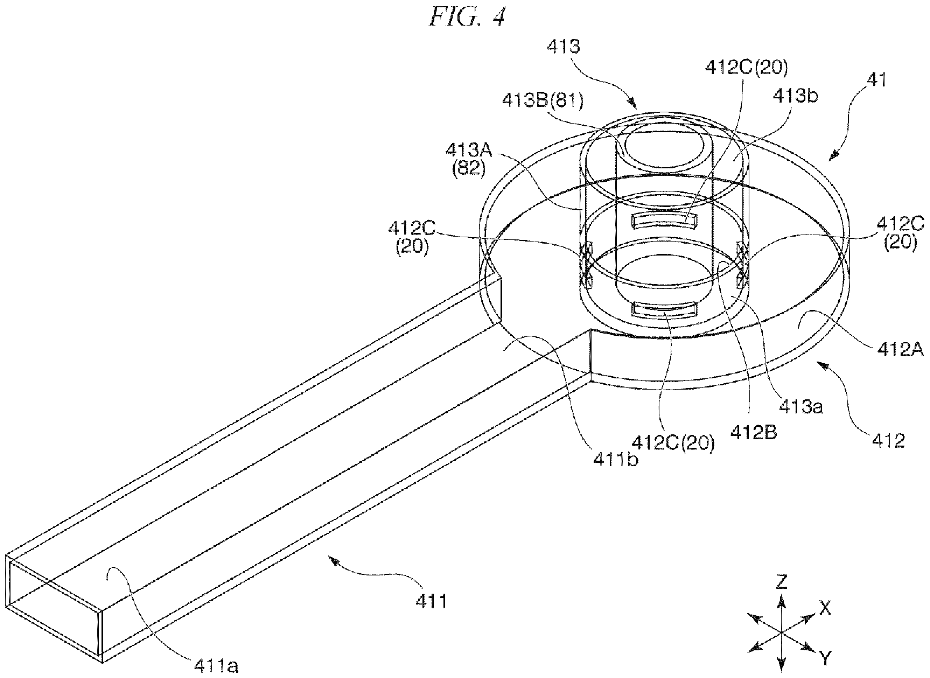

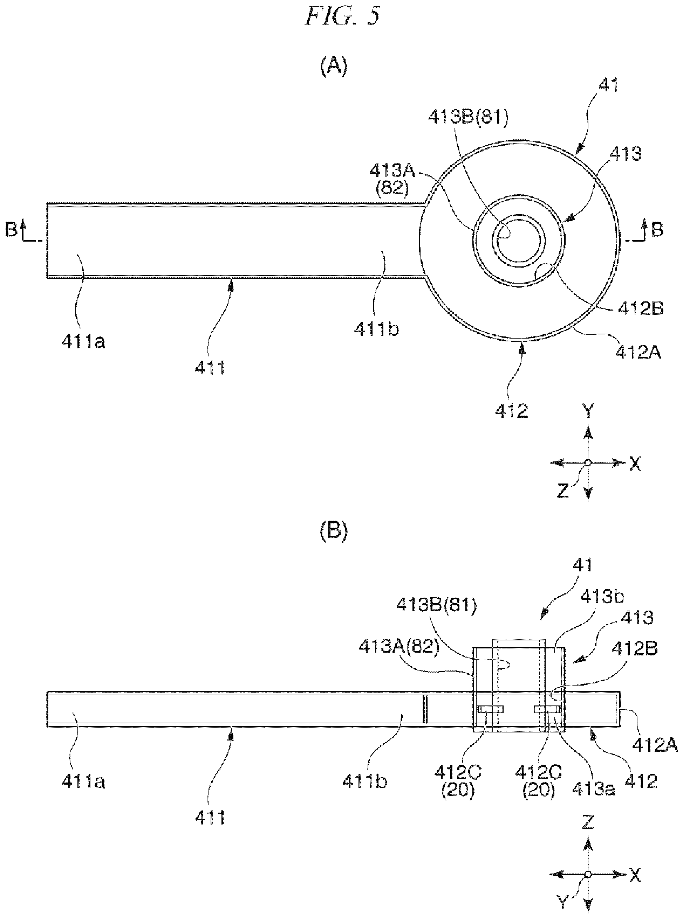

FIG. 4 is a perspective view showing a configuration of the microwave mode converter 41 provided on the coaxial structural portion 80A of FIG. 1, FIG. 5A is a plan view of the microwave mode converter 41 of FIG. 4, and FIG. 5B is a cross-sectional view along line B-B.

The microwave mode converter 41 has the rectangular waveguide tube 411, the ring-shaped resonator 412 coupled to the waveguide tube 411, and a coaxial structural portion 413 coupled to the resonator 412. The microwave mode converter 41 has the rectangular waveguide tube 411 and the coaxial structural portion 413 and therefore can also be called an applicator, which is a mode conversion coupler. However, the applicator of the present embodiment is significantly different from the applicator of the related art in that it has a ring-shaped resonator.

In the waveguide tube 411, one end portion 411a is connected to a circulator 90 (a side of the microwave oscillation source 50), and the other end portion 411b is connected to the resonator 412. The waveguide tube 411 has a rectangular shape in a cross-sectional view in a direction perpendicular to a propagation direction of the microwaves and has a straight shape in a plan view.

The resonator 412 has an outer circumferential side wall 412A and an inner circumferential side wall 412B, and the other end portion 411b of the waveguide tube 411 is connected to the outer circumferential side wall 412A. The resonator 412 has a rectangular shape in a cross-sectional view in a direction perpendicular to the propagation direction of the microwave and has a perfect circular shape in a plan view. In addition, the resonator 412 has a plurality of microwave introduction ports 412C, 412C, ... disposed side by side in a circumferential direction of the inner circumferential side wall 412B. In the present embodiment, the plurality of microwave introduction ports 412C, 412C, ... constitute the plurality of microwave introduction ports 20, 20, ... , but the present invention is not limited thereto. The plurality of microwave introduction ports 412C, 412C, ... and the plurality of microwave introduction ports 20, 20, ... may be provided separately from each other and directly connected to each other.

Opening surfaces of the plurality of microwave introduction ports 412C, 412C, ... are disposed parallel to the axial direction of the symmetric axis of the resonator 412 (the z direction), for example, the axial direction of the central conductor 81 and are disposed side by side to be rotationally symmetric in the circumferential direction of the inner circumferential side wall 412B with the symmetric axis of the resonator 412 as a reference. For example, the opening surfaces of the four microwave introduction ports 412C, 412C, ... are disposed side by side to be 90° rotationally symmetric in the circumferential direction of the inner circumferential side wall 412B. The opening surfaces of the plurality of microwave introduction ports 412C, 412C, ... have, for example, long sides and short sides, wherein the long sides are provided in the circumferential direction of the inner circumferential side wall 412B, and the short sides are provided in the axial direction of the central conductor 81. The opening surfaces of the plurality of microwave introduction ports 412C, 412C, ... preferably have the same shape, but may have different shapes as long as they do not affect radiation of the microwaves.

Each of the microwave introduction ports 412C is typically a linear or rectangular slit. The slit is disposed such that a long side thereof is parallel to a magnetic field direction at the slit or near the slit in correspondence with a resonance mode in the resonator 412 and such that a direction of a magnetic field formed in the coaxial structural portion 413 by the slit is the same as a direction of a magnetic field in the coaxial structural portion 413. The slit has, for example, a rectangular shape, but may have an elongated hole shape or the like.

The coaxial structural portion 413 has an outer circumferential side wall 413A and an inner circumferential side wall 413B and forms the coaxial structural portion 80A of the chamber 10A. One end portion 413a of the coaxial structural portion 413 is connected to the resonator 412 via the plurality of microwave introduction ports 20, 20, ... , and the other end portion 413b thereof becomes the coaxial opening portion 13 of the chamber 10A (see FIG. 3A). In the present embodiment, the inner circumferential side wall 413B constitutes the central conductor 81, and the outer circumferential side wall 413A constitutes the outer conductor 82. The coaxial structural portion 413 has a ring shape in cross-sectional view in a direction perpendicular to the propagation direction of the microwaves. In addition, in the present embodiment, the outer circumferential side wall 413A of the coaxial structural portion 413 and the inner circumferential side wall 412B of the resonator 412 form the same surface. In other words, it can be said that the plurality of microwave introduction ports 412C, 412C, ... are provided in the outer circumferential side wall 413A of the coaxial structural portion 413 and are disposed side by side in the circumferential direction thereof.

In the microwave mode converter 41 configured as described above, the microwaves introduced from one end portion 411a of the waveguide tube 411 are introduced from the other end portion 411b into the resonator 412 and are further transmitted to the coaxial structural portion 413 from the plurality of microwave introduction ports 412C, 412C, ... provided in the inner circumferential side wall 412B of the resonator 412. As a result, a transverse electric (TE) mode of the microwaves that are transmitted through the rectangular waveguide tube 411 is converted into a transverse electromagnetic (TEM) mode of the microwaves that are transmitted through the coaxial structural portion 413 via the ring-shaped resonator 412. The TE mode is generally a propagation mode in which an electric field direction is perpendicular to a traveling direction of electromagnetic waves, and the TEM mode is generally a propagation mode in which both the electric field direction and the magnetic field direction are perpendicular to the traveling direction of the electromagnetic waves. In the case of the present embodiment, the TE mode refers to, for example, a fundamental mode TE10. In this case, the magnetic field distribution within the chamber 10A is axially symmetric (circular).

In this way, the microwave mode converter 41 has the ring-shaped resonator 412, and the resonator 412 has the plurality of microwave introduction ports 412C, 412C, ... disposed side by side in the circumferential direction of the inner circumferential side wall 412B, and thus the microwaves in the resonance mode are introduced into the coaxial structural portion 413 from the plurality of microwave introduction ports 412C, 412C, .... As a result, it is possible to suppress the concentration of an electric field intensity within the microwave mode converter 41 and reduce the probability of abnormal discharge occurring within the waveguide tube. In addition, the configuration of the microwave mode converter 41 can be simplified and made small compared to the existing microwave mode converters. Furthermore, since the microwave mode converter 41 has the ring-shaped resonator 412, the diameter of the coaxial structural portion 413 (particularly the inner circumferential side wall 413B) can be increased. As a result, it becomes possible to ensure a sufficient space below an object to be processed to install mechanisms for cooling the object to be processed (crystal), automatically raising and lowering the object to be processed, and controlling the temperature distribution of the object to be processed, which are necessary in a case in which the object to be processed such as large bulk is produced.

In addition, the microwave plasma CVD device 1 includes a circulator 90 and an E-H tuner 100 provided in the waveguide portion 40A. The circulator 90 has a first port 91 coupled to a side of the microwave oscillation source 50, a second port 92 coupled to a side of the chamber 10A, and a third port 93 different from the first port 91 and the second port 92. The circulator 90 receives the microwaves from the microwave oscillation source 50 at the first port 91 and propagates the microwaves to the second port 92. In addition, the circulator 90 propagates the microwaves received at the second port 92, that is, the microwaves reflected from a microwave propagation component connected to the second port 92, to the third port 93. A non-reflective absorbing end called a dummy load is connected to the third port 93, and the microwaves propagated to the third port 93 are completely absorbed and converted into heat. As a result, the microwaves reflected from the microwave propagation component connected to the second port 92 are completely absorbed by the dummy load, and these microwaves do not return to a side of the microwave oscillation source 50. As a method for using such a circulator 90 and a dummy load, a general method for preventing the microwave oscillation source (such as a magnetron) from being thermally damaged by the reflected microwaves can be used. As a result, the microwaves generated by the microwave oscillation source 50 are supplied unidirectionally to the waveguide portion 40A. The E-H tuner 100 has an E tuner portion 101 and an H tuner portion 102 and adjusts impedance by moving plungers of the E tuner portion 101 and the H tuner portion 102 in or out. The E-H tuner 100 is one example of a method of adjusting the impedance, and another method, for example, a three-stub tuner, can be used.

The microwave oscillation source 50 oscillates microwaves at a predetermined frequency, for example, a frequency of 2.45 GHz or 915 MHz, which is in the ISM band. As the microwave oscillation source 50, for example, a magnetron or a semiconductor oscillator is used. In addition, in the microwave plasma CVD device 1 of the present embodiment, a cooling path using a medium such as cooling water or air may be provided above, on a side of, and below the chamber 10A.

In the microwave plasma CVD device 1 configured as described above, the microwaves supplied from the microwave oscillation source 50 are introduced into the chamber 10A through the plurality of microwave introduction ports 20, 20, ... provided in the coaxial structural portion 80A of the chamber 10A. The microwaves are applied to the raw material gas in the chamber 10A to cause discharge, thereby generating plasma in the chamber 10A. Then, a coating of a diamond or the like is formed on the surface of the workpiece W placed near the plasma from the raw material gas decomposed by the plasma.

As described above, according to the present embodiment, the plurality of microwave introduction ports 20, 20, ... are provided in the coaxial structural portion 80A of the chamber 10A and are coupled to match the internal resonance mode of the chamber 10A including the coaxial structural portion 80A. Therefore, by introducing the microwaves from the plurality of microwave introduction ports 20, 20, ... into the chamber 10A, the electric field concentration in the waveguide portion 40A (FIG. 2) and the coaxial structural portion 80A is alleviated, and abnormal discharge, heating associated with this, and the like can be suppressed even when high power microwaves are introduced, thereby improving power efficiency.

In addition, since the central conductor 81 under the workpiece W can be made thicker as needed, mechanisms required to control the crystal growth environment, such as raising and lowering a large area workpiece W and controlling the temperature (the distribution) of the large area workpiece W by cooling and heating the large area workpiece W, can be incorporated under a substrate electrode, thereby improving crystal quality and realizing the uniform synthesis of the large area substrate and the synthesis of thick bulk crystal.

In addition, since the plasma is generated above the mounting table 110A and the microwave introduction window 30A is provided at a position at which the microwave introduction window 30A is not exposed to the plasma generated within the chamber 10A, the microwave introduction window 30A can be prevented from being etched by the plasma. As a result, the elements that constitute the microwave introduction window, such as silicon, is prevented from being mixed into the workpiece W, making it possible to synthesize a high purity thin film of a material such as a diamond, thereby improving the quality of the object to be processed such as bulk. Furthermore, even when the high power microwaves are supplied, the plasma does not approach the microwave window, and thus it is possible to supply the high power microwaves and expand the film forming area on the workpiece W. Therefore, it is possible to produce the object to be processed such as large bulk while suppressing the increase in size of the device.

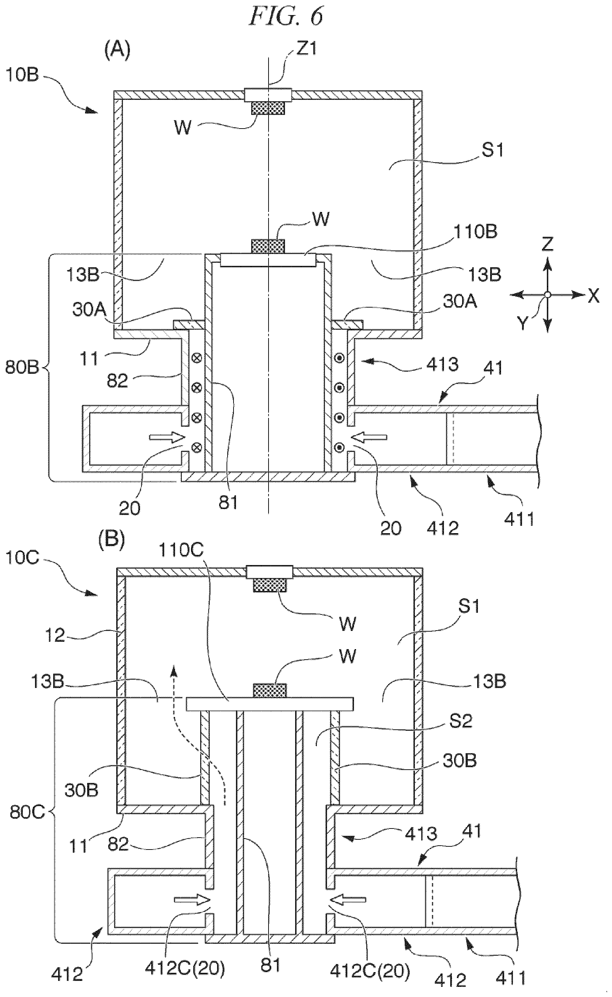

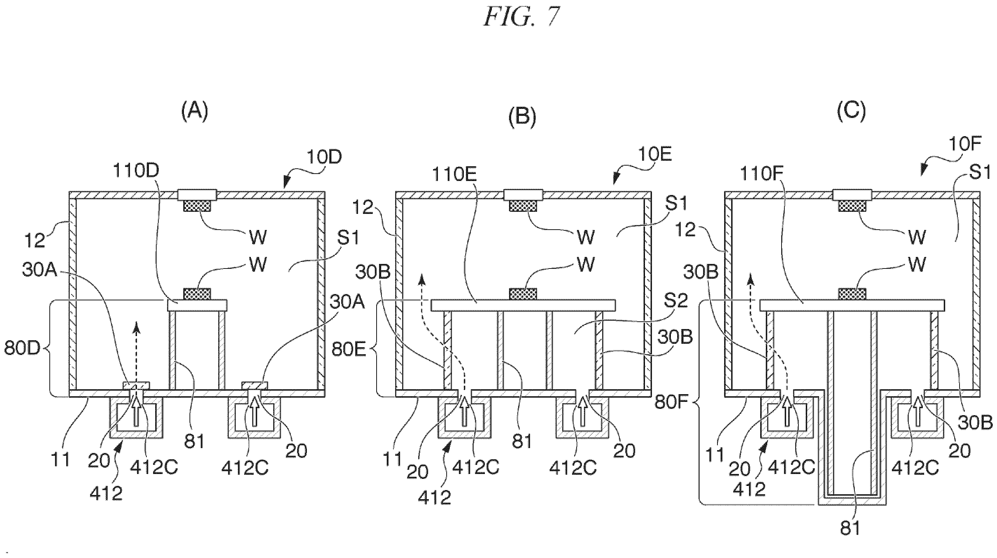

FIGS. 6A and 6B are cross-sectional views that schematically show modification examples of the microwave plasma CVD device 1 of FIG. 3A. FIGS. 7A to 7C are cross-sectional views that schematically show other modification examples of the microwave plasma CVD device 1 of FIG. 3A. The microwave introduction method in the configurations of FIGS. 6A and 6B is the same as the microwave introduction method in the configuration of FIGS. 1 to 5. That is, FIGS. 6A and 6B show the configurations in which the microwave introduction direction from the ring-shaped resonator 412 provided in a coaxial structural portion 80B or a coaxial structural portion 80C is perpendicular to the axis of each coaxial structural portion. In addition, FIGS. 7A to 7C show the configurations in which the microwave introduction direction from the ring-shaped resonator 412 provided in a coaxial structural portion 80D, a coaxial structural portion 80E, or a coaxial structural portion 80F is parallel to the axis of each coaxial structural portion.

As shown in FIG. 6A, a microwave introduction window 30A is disposed below a mounting table 110B. In other words, it is preferable that the mounting surface of the mounting table 110B, that is, the mounting position of the workpiece W, and the installation position of the microwave introduction window 30A be offset in the axial direction of the symmetric axis of a chamber 10B (the z-axis direction).

In addition, as shown in FIG. 6B, a mounting table 110C may have an outer diameter larger than the outer diameter of a central conductor 81 of the coaxial structural portion 80C of a chamber 10C, and a microwave introduction window 30B may be disposed below the mounting table 110C and extend in the axial direction of the symmetric axis of the chamber 10C. In this case, the microwave introduction window 30B has, for example, a cylindrical shape, and the microwave introduction window 30B forms a pressure partition wall between a sealed space S1 of the chamber 10C and a space S2 below the mounting table 110C. Since the plasma is generated above the mounting table 110C and the microwave introduction window 30B is provided at a position which is below the mounting table 110C and at which the microwave introduction window 30B is shielded by the mounting table 110C not to be exposed to the plasma, the microwave introduction window 30B can be prevented from being etched by the plasma.

In FIG. 7A, a plurality of microwave introduction ports 20, 20, ... are provided in the coaxial structural portion 80D of a chamber 10D and are coupled to match the internal resonance mode of the chamber 10D. An introduction direction of the microwaves introduced from the plurality of microwave introduction ports 20, 20, ... is parallel to the axial direction of the symmetric axis of the internal resonance mode of the chamber 10D or the axial direction of a central conductor 81. In this case, the opening surfaces of the plurality of microwave introduction ports 20, 20, ... are disposed around the central conductor 81 in a plan view of the chamber 10D and are provided perpendicular to the axial direction of the central conductor 81. The plurality of microwave introduction ports 20, 20, ... are provided in a part of the coaxial structural portion 80D, that is, in a bottom wall 11 of the chamber 10D. The plurality of microwave introduction ports 20, 20, ... are provided directly above a plurality of microwave introduction ports 412C, 412C, ... provided in a ring-shaped resonator 412. A mounting table 110D is provided on the upper end portion of the central conductor 81.

In addition, the ring-shaped resonator 412 is disposed directly below the chamber 10D. The ring-shaped resonator 412 has the plurality of microwave introduction ports 412C, 412C, ... provided in the upper surface of the ring-shaped resonator 412. The plurality of microwave introduction ports 412C, 412C, ... are directly connected to the plurality of microwave introduction ports 20, 20, .... The opening surface of the microwave introduction port 412C of the ring-shaped resonator 412 and the opening surface of the microwave introduction port 20 are provided perpendicular to the axial direction of the central conductor 81 (the z direction). In the present embodiment, the plurality of microwave introduction ports 412C, 412C, ... and the plurality of microwave introduction ports 20, 20, ... are provided separately from each other, but the plurality of microwave introduction ports 412C, 412C, ... may constitute the plurality of microwave introduction ports 20, 20, ... .

In addition, as shown in FIG. 7B, a mounting table 110E may have an outer diameter larger than the outer diameter of the central conductor 81, and a microwave introduction window 30B may be disposed below the mounting table 110E and extend in the axial direction of the symmetric axis of the chamber 10E. In this case, the microwave introduction window 30B has, for example, a cylindrical shape, and the microwave introduction window 30B forms a pressure partition wall between a sealed space S1 of the chamber 10E and a space S2 below the mounting table 110E. Since the plasma is generated above the mounting table 110E and the microwave introduction window 30B is provided at a position which is below the mounting table 110E and at which the microwave introduction window 30B is shielded by the mounting table not to be exposed to the plasma, the microwave introduction window 30B can be prevented from being etched by the plasma.

In addition, as shown in FIG. 7C, the central conductor 81 supporting a mounting table 110F may extend downward of a chamber 10F. In this case, the ring-shaped resonator 412 is disposed below the chamber 10F, and the microwave introduction port 20 is provided on a side in a radial direction (an x direction) from the central conductor 81. By varying the length of the downward extending coaxial structural portion 80F, the resonance mode within the chamber 10F can be adjusted.

In this way, according to the embodiment shown in FIG. 7A, since the plasma is generated above the mounting table 110D and the microwave introduction window 30A is provided below the mounting table 110D, the microwave introduction window 30B can be prevented from being etched by the plasma. In addition, according to the embodiments shown in FIGS. 7B and 7C, since the plasma is generated above the mounting table 110E and the microwave introduction window 30B is provided at a position which is below the mounting table 110E and at which the microwave introduction window 30B is shielded by the mounting table 110E not to be exposed to the plasma, the microwave introduction window 30B can be further prevented from being etched by the plasma. In addition, similar to this, since the plasma is generated above the mounting table 110F and the microwave introduction window 30B is provided at a position which is below the mounting table 110F and at which the microwave introduction window 30B is shielded by the mounting table 110F not to be exposed to the plasma, the microwave introduction window 30B can be further prevented from being etched by the plasma.

In the microwave plasma CVD device shown in FIGS. 3 to 6, in replacement of the ring-shaped resonator for introducing the microwaves from the plurality of ports, a waveguide tube may be connected to each microwave introduction port individually.

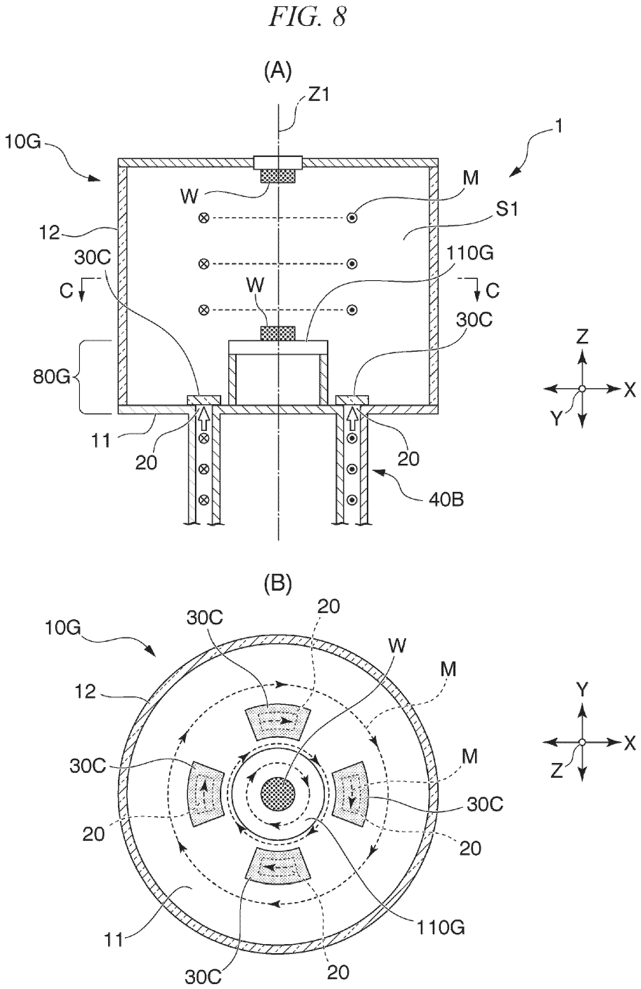

FIG. 8 shows an example in which the ring-shaped resonator of FIG. 7A is replaced with a plurality of waveguide tubes.

FIG. 8A is a side view that schematically shows a modification example of the microwave plasma CVD device of FIG. 6A, and FIG. 8B is a cross-sectional view along line C-C. The configuration of the microwave plasma CVD device in FIGS. 8A and 8B is basically the same as the configuration of the microwave plasma CVD device in FIG. 6A, and thus the common portions are given the same reference signs and the description thereof are omitted, and the different portions will be described below.

As shown in FIGS. 8A and 8B, the microwave plasma CVD device 1 includes a plurality of microwave introduction ports 20, 20, ... that are provided in a coaxial structural portion 80G of a chamber 10G and are coupled to match the internal resonance mode of the chamber 10G, and a plurality of microwave introduction windows 30C, 30C, ... that transmit microwaves while forming a pressure partition wall between the chamber 10G and a waveguide portion 40B. The waveguide portion 40B is constituted by, for example, a plurality of rectangular waveguide tubes, and in the present embodiment, four rectangular waveguide tubes are disposed around the symmetric axis of the chamber 10G. In the configuration shown in FIGS. 8A and 8B, the microwaves are introduced from the plurality of microwave introduction ports 20, 20, ... in parallel with the axial direction of the symmetric axis of the internal resonance mode of the chamber 10G. Near the opening surfaces of the plurality of microwave introduction ports 20, 20, ... , the waveguide 40B is coupled to the chamber 10G such that a direction M of the magnetic field of the internal resonance mode of the chamber 10G matches a direction M of the magnetic field within each rectangular waveguide tube of the waveguide portion 40B in the TE mode.

In the present embodiment, the internal resonance mode of the chamber 10G is axially symmetric, and an introduction direction of the microwaves introduced from the plurality of microwave introduction ports 20, 20, ... is parallel to the symmetric axis of the internal resonance mode of the chamber 10G. In other words, the normal line at the center of an opening surface of each of the plurality of microwave introduction ports 20, 20, ... is parallel to the symmetric axis. In this case, the opening surfaces of the plurality of microwave introduction ports 20, 20, ... are provided perpendicular to the axial direction of the symmetric axis of the internal resonance mode of the chamber 10G (the z direction) in a plan view of the chamber 10G. Each of the opening surfaces of the plurality of microwave introduction ports 20, 20, ... has, for example, long sides and short sides, and the in-plane direction of the opening surface defined by the long sides and the short sides is provided perpendicular to the axial direction of the symmetric axis of the internal resonance mode (the z direction). The plurality of microwave introduction ports 20, 20, ... preferably have the same shape, but may have different shapes as long as they do not affect radiation of the microwaves.

The opening surfaces of the plurality of microwave introduction ports 20, 20, ... are disposed in the circumferential direction of the chamber 10G with the symmetric axis of the internal resonance mode of the chamber 10G as a reference in a plan view of the chamber 10G. For example, the opening surfaces of the four microwave introduction ports 20, 20, ... are disposed side by side to be 90° rotationally symmetric in the circumferential direction of the chamber 10G. The opening surface of the microwave introduction port 20 has, for example, the long sides and the short sides, wherein the long sides are provided in the circumferential direction of the chamber 10G, and the short sides are provided in the axial direction of the symmetric axis of the above internal resonance mode.

Each of the microwave introduction ports 20 is typically a linear or rectangular slit. The long side of the slit is disposed parallel to the direction of a magnetic field M near the slit. As a result, an electric field parallel to the short side of the slit is generated, and the slit functions as an antenna that radiates electromagnetic waves from the opening portion thereof. The slit has, for example, an arc shape, but may have a rectangular shape, an elongated hole shape, or the like.

In the present embodiment, the plurality of microwave introduction windows 30C, 30C, ... are mounted on the bottom wall 11 of the chamber 10G to cover the plurality of microwave introduction ports 20, 20, .... The plurality of microwave introduction windows 30C, 30C, ... are placed between the chamber 10G (a reduced pressure region) and the waveguide portion 40B (an atmospheric pressure region).

Similar to the plurality of microwave introduction ports 20, 20, ... , the plurality of microwave introduction windows 30C, 30C, ... are also disposed in the circumferential direction of the chamber 10G with the symmetric axis of the internal resonance mode of the chamber 10G as a reference in a plan view of the chamber 10G. For example, the four microwave introduction windows 30C, 30C, ... are disposed side by side to be 90° rotationally symmetric in the circumferential direction of the chamber 10G. The microwave introduction window 30C is not limited to an arc shape and may have a rectangular shape, an elongated hole shape, or the like, or may be a single ring shape without being divided as long as it can close the microwave introduction port 20.

In this way, the microwave plasma CVD device 1 may be configured such that the microwaves are introduced into the chamber 10G by the waveguide portion 40B made up of a plurality of rectangular waveguide tubes, for example. In this case, the microwaves are introduced into each microwave introduction port with the same phase. According to the present configuration, the abnormal discharge in the waveguide portion 40B can also be suppressed, the crystal quality can be improved by ensuring good access to the crystal, and the object to be processed such as large bulk can be produced.

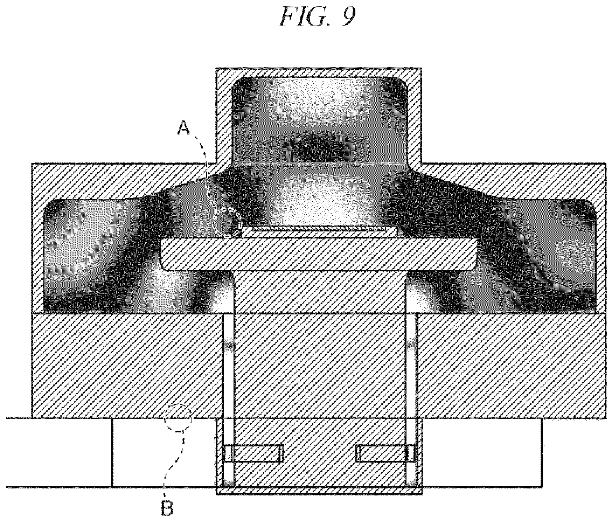

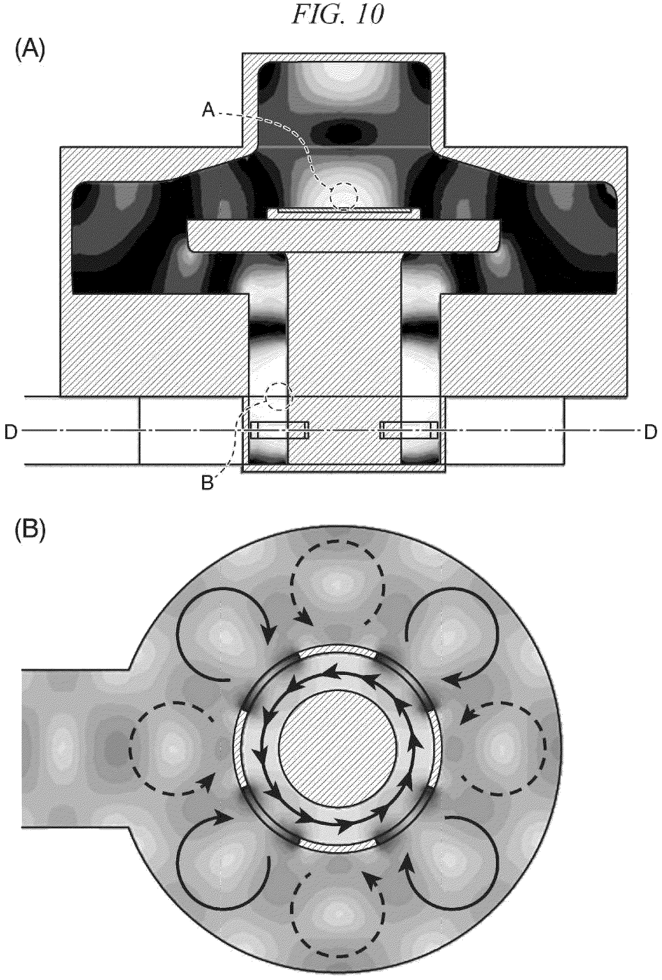

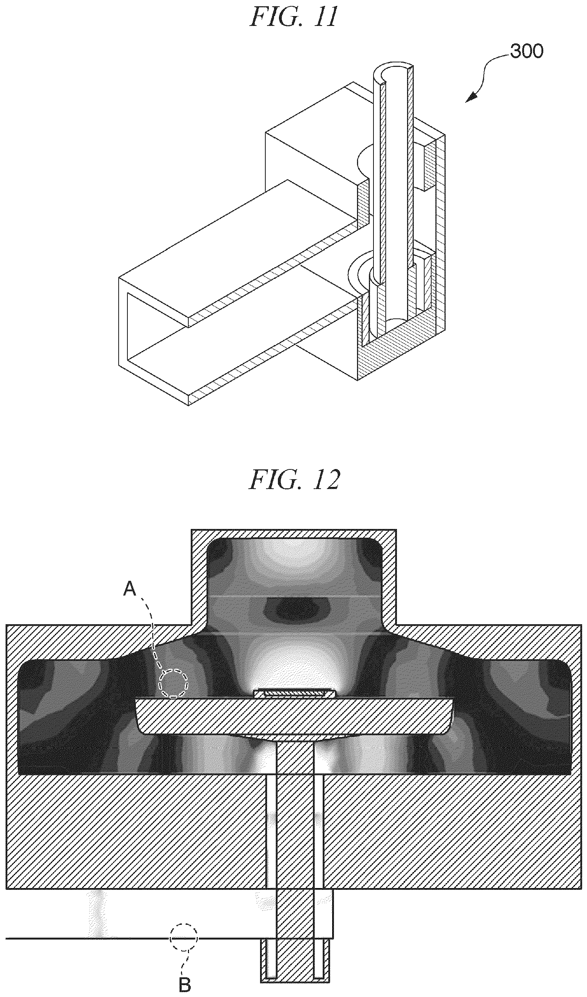

FIG. 9 is a diagram showing a distribution of an electric field intensity obtained by a simulation of Example 1. FIG. 10A is a diagram showing a distribution of an electric field intensity obtained by a simulation of Example 2, and FIG. 10B is a diagram showing the distribution of the magnetic field intensity in a cross section along line D-D. FIG. 11 is a perspective view showing a configuration of a microwave mode converter in a microwave plasma CVD device of the related art. FIG. 12 is a diagram showing a distribution of an electric field intensity obtained by a simulation of Comparative Example 1.

As Example 1, a structure equivalent to the configuration shown in FIG. 6A was designed in a simulation, and the numerical calculation was performed to calculate the electric field intensity distribution. The simulation software used was JMAG-Studio (manufactured by JSOL). The calculation method used was the finite element method or the iterative method, the number of elements was approximately 1 million (tetra mesh), the model size was 1 m × 0.4 m × 0.3 m, the input microwave had a frequency of 2.45 GHz, the mode was TE10, and as the boundary conditions, the portion except for the input/output port (the rectangular waveguide tube end) and the microwave introduction window through which the microwaves are input was made of a perfect conductor.

In FIG. 9, the electric field intensity calculated by the simulation is shown as gray scale shading. In addition, the electric field intensity was calculated in a region A in FIG. 9 corresponding to a substrate placement portion as a measurement region for the electric field intensity, and the electric field intensity was calculated in a region B in FIG. 9 corresponding to the waveguide tube or the coaxial structural portion as a measurement region for the electric field intensity.

As Example 2, a structure (FIG. 10A) in which the width of the coaxial structural portion in the radial direction was made larger than that of Example 1 was designed, and the numerical calculation was performed in the same manner as in Example 1 to calculate the electric field intensity distribution.

In addition, FIG. 10B shows the calculation results of the magnetic field intensity distribution in the D-D cross section of the ring-shaped resonator in FIG. 10A and the general directions of magnetic field lines in the ring-shaped resonator and the coaxial structural portion are indicated by arrows. The plurality of microwave introduction ports that are provided on the inner circumferential portion of the ring-shaped resonator are disposed such that the directions of the magnetic field lines match each other at the boundary between the ring-shaped resonator and the coaxial structural portion. In this way, the TE mode of the microwaves that are transmitted through the rectangular waveguide tube is converted into the TEM mode of the microwaves that are transmitted through the coaxial structural portion via the ring-shaped resonator.

In addition, as Comparative Example 1, a microwave mode converter provided in a microwave plasma CVD device of the related art was used. In an ASTeX6500 type of microwave plasma CVD device of the related art, microwaves are introduced into a resonator type chamber via a microwave mode converter 300 (FIG. 11) located below the chamber, and a predetermined electric field intensity is obtained at a substrate placement portion. That is, the microwave mode converter of the related art has a structure that includes a rectangular waveguide tube and a coaxial line path and does not include a ring-shaped resonator. As Comparative Example 1, a structure (FIG. 12) corresponding to this microwave mode converter of the related art was designed, and the numerical calculation was performed to calculate the electric field intensity distribution.
Table 1 shows the calculation results of the electric field intensity in each of the region A and the region B and the ratio of the electric field intensity in the region A to the electric field intensity in the region B (the specific intensity) in Examples 1 and 2 and Comparative Example 1.

**[Table 1]**

| | Electric field intensity in region A | Electric field intensity in region B | Specific intensity (region A / region B) |
|---|---|---|---|
| | [V/m] | [V/m] | [-] |
| Example 1 | 4.0 × 10³ | 1.5 × 10⁴ ~ 2.5 × 10⁴ | 0.2 ~ 0.3 |
| Example 2 | 5.0 × 10³ | 2.0 × 10³ ~ 7.0 × 10³ | 0.7 ~ 2.5 |
| Comparative Example 1 | 5.0 × 10³ | 1.0 × 10⁵ ~ 1.5 × 10⁵ | 0.05 ~ 0.3 |

From the results in Table 1, in Example 1, when the microwaves were introduced into the chamber from the rectangular waveguide tube via the ring-shaped resonator having the plurality of slits on the side wall thereof, a high electric field intensity equivalent to that of Comparative Example 1 could be obtained in the region A, that is, the substrate placement portion. In addition, the ratio of the electric field intensity in the region A to the electric field intensity in the region B (the specific intensity) was 0.2 to 0.3, and it was found that the probability of the abnormal discharge occurring in the region B, that is, the waveguide tube, could be reduced compared to Comparative Example 1.

In addition, in Example 2, even if the width of the coaxial structural portion in the radial direction was made larger than that of Example 1, a high electric field intensity equivalent to that of Comparative Example 1 could be obtained in the region A, that is, the substrate placement portion. In addition, the ratio of the electric field intensity in the region A to the electric field intensity in the region B (the specific intensity) was 0.7 to 2.5, which is significantly greater than the specific intensity in Example 1, and it was found that the probability of the abnormal discharge occurring in the region B, that is, the waveguide tube, could be further reduced.

On the other hand, in Comparative Example 1, when the microwaves were introduced into the coaxial line path from the rectangular waveguide tube without passing through the resonator, the ratio of the electric field intensity in the region A to the electric field intensity in the region B (the specific intensity) was 0.05 to 0.3, and it was found that the probability of the abnormal discharge occurring was higher than in either of Examples 1 or 2.

The present invention is not necessarily limited to the embodiments described above, and various modifications can be made without departing from the spirit of the present invention.

For example, in the present embodiment, in the configuration of FIG. 3, the coaxial structural portion 80A is provided on the bottom wall 11 of the chamber 10A, but the present invention is not limited thereto. As long as the coaxial structural portion is coupled to match the internal resonance mode of the chamber 10A and the microwave introduction window 30A is provided at a position at which the microwave introduction window 30A is not exposed to the plasma generated in the chamber 10A, the installation positions of the coaxial structural portion and the microwave introduction window 30A are not particularly limited. The microwave introduction window 30A may be provided at a position other than on and near the in-plane direction extension of the workpiece W, for example. In addition, the microwave introduction window 30A can also be expressed as being installed at a position that is not visually seen from the workpiece W on the bottom wall 11 or at a position that is not visible from the workpiece W on the bottom wall 11. As a result, it is possible to highly purify the diamond deposited or grown on the workpiece W while the microwave introduction window is prevented from being etched by the plasma generated on the workpiece W.

In addition, the waveguide portion 40A may have the rectangular waveguide tube 411 and the ring-shaped resonator 412 coupled to the waveguide tube 411 without the coaxial structural portion 413. In this case, the resonator 412 may have one or more microwave introduction ports on the upper surface of the resonator 412 and may also function as a coaxial waveguide tube. More specifically, in the configuration of FIG. 7A, the microwave plasma CVD device 1 may not have the coaxial structural portion 80D, and the mounting table 110D may be provided on the bottom wall 11 of the chamber 10D. In this case, the microwave plasma CVD device 1 may include the raw material gas introduction portion 60 (see FIGS. 1 and 2) for introducing the raw material gas into the chamber 10D, the plurality of microwave introduction ports 20, 20, ... coupled to match the internal resonance mode of the chamber 10D, the microwave introduction window 30A (see FIGS. 1 and 2) which transmits the microwaves while forming the pressure partition wall between the chamber 10D and the waveguide portion, the waveguide portion 40A (see FIGS. 1 and 2) connected to the plurality of microwave introduction ports 20, 20, ... , and the microwave oscillation source 50 (see FIGS. 1 and 2) connected to the waveguide portion 40A.

Furthermore, the workpiece W is placed on both the bottom wall and the top wall of the chamber 10A, but the present invention is not limited thereto, and the workpiece W may be placed on either the bottom wall or the top wall of the chamber 10A.

### REFERENCE SIGNS LIST

1 Microwave plasma CVD device
10A Chamber
10B Chamber
10C Chamber
10D Chamber
10E Chamber
10F Chamber
10G Chamber
11 Bottom wall
12 Side wall
13 Coaxial opening portion
20 Microwave introduction port
30A Microwave introduction window
30B Microwave introduction window
30C Microwave introduction window
40A Waveguide portion
40B Waveguide portion
41 Microwave mode converter
50 Microwave oscillation source
60 Raw material gas introduction portion 70 Gas exhaust portion
80A Coaxial structural portion
80B Coaxial structural portion
80C Coaxial structural portion
80D Coaxial structural portion
80E Coaxial structural portion
80F Coaxial structural portion
80G Coaxial structural portion
81 Central conductor
82 Outer conductor
90 Circulator
91 First port
92 Second port
93 Third port
100 E-H tuner
101 E tuner portion
102 H tuner portion
110A Mounting table
110B Mounting table
110C Mounting table
110D Mounting table
110E Mounting table
110F Mounting table
110G Mounting table
411 Waveguide tube
411a One end portion
411b The other end portion
412 Resonator
412A Outer circumferential side wall
412B Inner circumferential side wall
412C Microwave introduction port
413 Coaxial structural portion
413A Outer circumferential side wall
413B Inner circumferential side wall

## Claims

1. A microwave plasma CVD device comprising:
a chamber;
a mounting table provided in a central portion of the chamber in a plan view of the chamber;
a raw material gas introduction portion for introducing a raw material gas into the chamber;
a gas exhaust portion for exhausting gas from the chamber;
a plurality of microwave introduction ports coupled to match an internal resonance mode of the chamber;
one or more microwave introduction windows that transmit microwaves while forming a pressure partition wall between the chamber and a waveguide portion;
the waveguide portion connected to the plurality of microwave introduction ports; and
a microwave oscillation source connected to the waveguide portion.

2. The microwave plasma CVD device according to claim 1, further comprising a coaxial structural portion that includes a central conductor which is located at a central portion of the chamber in a plan view of the chamber and is parallel to an axial direction of a symmetric axis of the internal resonance mode of the chamber and an outer conductor located around the central conductor,
wherein the plurality of microwave introduction ports are provided in the coaxial structural portion of the chamber.

3. The microwave plasma CVD device according to claim 1 or 2, wherein an introduction direction of the microwaves introduced from the plurality of microwave introduction ports is parallel to an axial direction of a symmetric axis of the internal resonance mode of the chamber or an axial direction of the central conductor.

4. The microwave plasma CVD device according to claim 2, wherein an introduction direction of the microwaves introduced from the plurality of microwave introduction ports is perpendicular to the axial direction of the symmetric axis of the internal resonance mode of the chamber or an axial direction of the central conductor.

5. The microwave plasma CVD device according to claim 2, wherein opening surfaces of the plurality of microwave introduction ports are disposed around the central conductor in a plan view of the chamber and are provided parallel to an axial direction of the central conductor.

6. The microwave plasma CVD device according to claim 2, wherein opening surfaces of the plurality of microwave introduction ports are disposed around the central conductor in a plan view of the chamber and are provided perpendicular to an axial direction of the central conductor.

7. The microwave plasma CVD device according to claim 1 or 2, wherein opening surfaces of the plurality of microwave introduction ports are disposed in a circumferential direction of the chamber with a symmetric axis of the internal resonance mode of the chamber or a central axis of the central conductor as a reference in a plan view of the chamber.

8. The microwave plasma CVD device according to claim 2,
wherein the waveguide portion includes a rectangular waveguide tube and a ring-shaped resonator that is coupled to the rectangular waveguide tube and is provided on the coaxial structural portion of the chamber,
wherein the ring-shaped resonator is coupled to the coaxial structural portion via the plurality of microwave introduction ports provided in the resonator, and
wherein a TE mode of the microwaves that are transmitted through the rectangular waveguide tube is converted into a TEM mode of the microwaves that are transmitted through the coaxial structural portion via the ring-shaped resonator.

9. A microwave mode converter comprising a rectangular waveguide tube, a ring-shaped resonator coupled to the waveguide tube, and a coaxial structural portion coupled to the resonator,
wherein a TE mode of microwaves that are transmitted through the rectangular waveguide tube is converted into a TEM mode of the microwaves that are transmitted through the coaxial structural portion via the ring-shaped resonator.

10. The microwave mode converter according to claim 9, wherein the resonator has an outer circumferential side wall and an inner circumferential side wall and has a plurality of microwave introduction ports disposed side by side in a circumferential direction of the inner circumferential side wall.

11. The microwave mode converter according to claim 10, wherein opening surfaces of the plurality of microwave introduction ports are provided parallel to an axial direction of a symmetric axis of the resonator and are disposed side by side to be rotationally symmetric in the circumferential direction of the inner circumferential side wall with the symmetric axis of the resonator as a reference.

12. The microwave mode converter according to claim 10 or 11,
wherein each of the microwave introduction ports is a linear or rectangular slit, and
wherein the slit is disposed such that a long side thereof is parallel to a magnetic field direction at the slit in correspondence with a resonance mode in the resonator and such that a direction of a magnetic field formed in the coaxial structural portion by the slit is the same as a direction of a magnetic field in the coaxial structural portion.
